# FASCICULE DE BREVET EUROPEEN

(11) **EP 1 480 257 B1**
(45) Date de publication et mention de la délivrance du brevet: **02.11.2006**
(21) Numéro de dépôt: 04291220.4
(22) Date de dépôt: 12.05.2004
(51) Int. Cl.: H01L 21/02

(54) **Procédé de réalisation d'un circuit électronique intégré comprenant un condensateur**
Herstellungsverfahren einer mit einem Kondensator integrierten elektronischen Schaltung
Method of manufacturing an electronic integrated circuit having a capacitor

(30) Priorité: 20.05.2003 FR 0306031
(43) Date de publication de la demande: 24.11.2004
(73) Titulaire: STMicroelectronics S.A., 92120 Montrouge (FR)
(72) Inventeur: Delpech, Philippe, 38240 Meylan (FR); Regnier, Christophe, 38660 St Hilaire du Touvet (FR); Cremer, Sébastien, 38000 Grenoble (FR)
(74) Mandataire: Loisel, Bertrand

(56) Documents cités:
- US-A- 5 049 957
- US-A- 5 479 316
- US-B1- 6 551 399

## Description

La présente invention concerne un procédé de réalisation d'un circuit électronique intégré comprenant un condensateur.

D'une façon connue, les circuits électroniques intégrés actuellement réalisés peuvent comprendre un ou plusieurs condensateurs formés lors de l'intégration du circuit. De tels condensateurs sont élaborés par dépôts successifs de matériaux sur le substrat du circuit. Ils sont généralement disposés au sein de couches de matériaux isolants qui recouvrent le substrat, et qui comprennent, par ailleurs, des connexions électriques reliant des composants du circuit.

Un type particulièrement utilisé de condensateur intégré est désigné par MIM, pour «Métal-Isolant-Métal». Un tel condensateur est généralement formé de deux armatures métalliques planes disposées en vis-à-vis, parallèlement à la surface du substrat, et séparées par au moins une couche d'un matériau diélectrique isolant électriquement. En fonction de la capacité désirée, les armatures d'un condensateur MIM peuvent avoir une longueur qui atteint 140 micromètres, par exemple. Un tel condensateur occupe donc une portion importante de la surface du substrat du circuit. Il correspond alors à une part significative du prix de revient du circuit électronique, proportionnelle à la surface de substrat occupée.

Un condensateur est divulgué dans le document US-A-5 049 957.

Il est donc intéressant de réduire les dimensions d'un condensateur intégré, à capacité égale. Pour cela, il est connu de réduire l'épaisseur du matériau diélectrique de séparation des armatures, selon la direction perpendiculaire aux armatures.

Or, la réduction de l'épaisseur du matériau diélectrique est limitée par la qualité du matériau diélectrique, lorsque le matériau diélectrique est réalisé sous forme d'une couche de faible épaisseur. En effet, en dessous d'une épaisseur de 30 nanomètres environ, la couche de matériau diélectrique présente en général une structure irrégulière, rugueuse et mal contrôlée.

Cette limitation est particulièrement importante pour un condensateur MIM réalisé par dépôt d'une armature métallique inférieure au dessus du substrat, suivi du dépôt de la couche de matériau diélectrique sur l'armature inférieure, puis du dépôt d'une armature métallique supérieure sur la couche de matériau diélectrique. En effet, une telle formation du matériau diélectrique sur le matériau métallique de l'armature inférieure engendre en général une nucléation du matériau diélectrique par îlots disjoints, appelée nucléation tridimensionnelle. La structure de la couche de matériau diélectrique est alors fortement irrégulière.

Par ailleurs, une diffusion des atomes du matériau diélectrique dans le métal de l'armature inférieure intervient en outre fréquemment lors du dépôt du matériau diélectrique. Les propriétés électriques de l'électrode inférieure sont alors altérées. De même, une diffusion des atomes de l'électrode métallique inférieure dans le matériau diélectrique, lors du dépôt du matériau diélectrique, réduit la capacité d'isolation électrique de la couche de matériau diélectrique. Ces diffusions atomiques sont favorisées par un chauffage du circuit nécessaire pour le dépôt du matériau diélectrique.

Enfin, un alliage peut être formé par réaction chimique entre le métal de l'électrode inférieure et le matériau diélectrique, lors du dépôt de ce dernier.

Chacun de ces phénomènes augmente les risques de claquage de la couche de matériau diélectrique, et réduit la fiabilité du circuit intégré obtenu.

Un but de l'invention est la réalisation d'un condensateur intégré qui ne présente pas les inconvénients ci-dessus, ou pour lequel ces inconvénients sont diminués.

L'invention propose un procédé de réalisation d'un circuit électronique intégré comprenant un condensateur, le procédé comprenant les étapes suivantes :
a) formation d'un empilement comprenant :
   - un premier volume d'un matériau temporaire disposé sur une partie d'un substrat,
   - un second volume d'au moins un matériau diélectrique isolant électriquement disposé sur le premier volume, d'un côté du premier volume opposé au substrat, et
   - un troisième volume d'un premier matériau conducteur électrique disposé au-dessus du deuxième volume, d'un côté du deuxième volume opposé au premier volume, de façon à former une première armature du condensateur ;
b) dépôt d'un matériau d'enrobage isolant électrique sur le circuit de façon à recouvrir l'empilement et une partie au moins du circuit en dehors de ladite partie du substrat ;
c) formation d'au moins une cheminée d'accès entre une surface du matériau d'enrobage et le premier volume ;
d) évacuation d'une partie au moins du matériau temporaire par la cheminée d'accès de façon à évider une portion au moins du premier volume ; et
e) introduction d'un second matériau conducteur par la cheminée d'accès dans la portion évidée du premier volume, de façon à former une seconde armature du condensateur.

Ainsi, selon l'invention, le matériau temporaire du premier volume, sur lequel est disposé le second volume de matériau diélectrique, peut être sélectionné indépendamment du second matériau conducteur, qui constitue la seconde armature du condensateur. En particulier, le matériau temporaire peut être sélectionné pour favoriser une structure régulière du matériau diélectrique du second volume, lorsque le second volume présente une faible épaisseur selon la direction de l'empilement. Des caractéristiques du condensateur obtenu sont alors améliorées, telles que sa résistance au claquage ou le courant de fuite entre les électrodes du condensateur. Par ailleurs, la structure régulière du matériau diélectrique du second volume peut aussi permettre de réduire l'épaisseur du second volume. A capacité égale du condensateur, les dimensions des armatures parallèlement au substrat sont alors plus petites.

En outre, grâce à l'invention, le second matériau conducteur, qui remplace le matériau temporaire dans le premier volume, peut être un matériau métallique sélectionné pour présenter une valeur élevée de travail de sortie («work function» en anglais), sans que cette exigence soit combinée avec celle d'un second matériau conducteur adapté pour obtenir une structure régulière du second volume de matériau diélectrique. En effet, cette dernière exigence est dévolue au choix du matériau temporaire, et non à celui du second matériau conducteur. La sélection du second matériau conducteur en est facilitée.

D'autres particularités et avantages de la présente invention apparaîtront dans la description ci-après d'un mode de mise en oeuvre non limitatif, en référence aux dessins annexés, parmi lesquels :

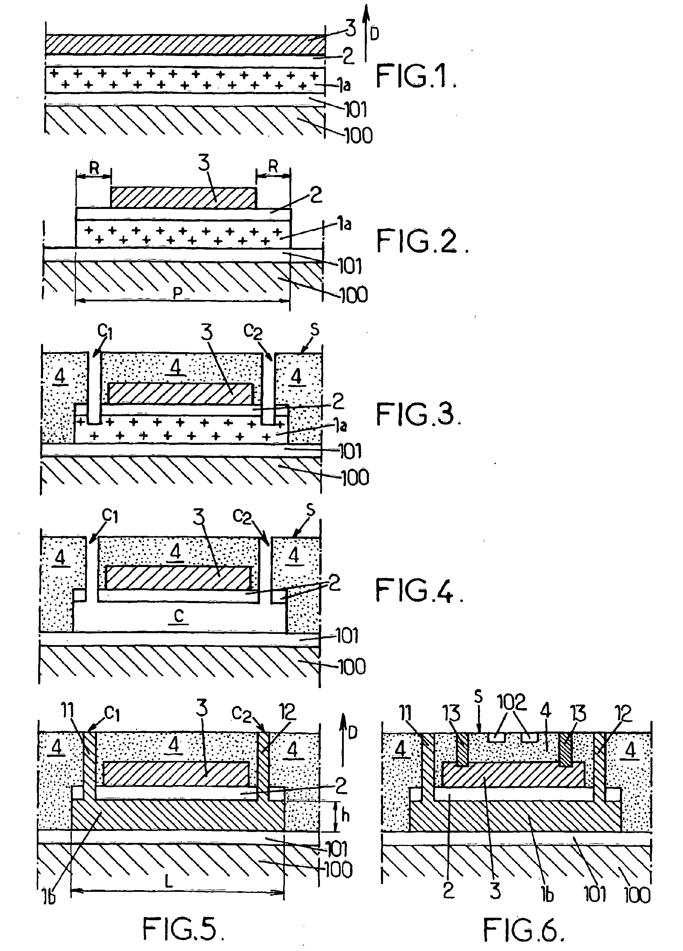

- les figures 1 à 6 illustrent différentes étapes d'un procédé de fabrication d'un condensateur selon l'invention.

Dans ces figures, pour raison de clarté, les dimensions des différentes parties de composants représentées ne sont pas en proportion avec leurs dimensions réelles. Ces figures sont des vues en coupe d'un substrat sensiblement plan sur lequel est élaboré un condensateur de type MIM. Les vues en coupe sont considérées dans un plan perpendiculaire à la surface du substrat. Le substrat est placé dans la partie inférieure de chaque figure, et D désigne une direction perpendiculaire à la surface du substrat, orientée vers le haut des figures. Dans la suite, les termes «sur», «sous», «inférieur» et «supérieur» sont utilisés en référence à cette orientation. Par ailleurs, sur toutes les figures, des références identiques correspondent à des éléments identiques.

Dans ce qui suit, les étapes élémentaires de procédé de fabrication d'un circuit électronique intégré connues de l'Homme du métier ne sont pas décrites en détail. On s'attache seulement à décrire une succession d'étapes élémentaires qui permet de réaliser un condensateur selon le procédé de l'invention.

Selon la figure 1, un substrat 100, par exemple de silicium, est recouvert d'une couche 101 de matériau isolant, par exemple de silice (SiO₂). On dépose alors successivement, sur la couche 101, une couche 1 a de matériau temporaire, une couche 2 de matériau diélectrique isolant, et une couche 3 d'un premier matériau métallique. Les épaisseurs, selon la direction D, des couches 1a, 2 et 3 sont, par exemple, environ 300 nanomètres, 30 nanomètres, et 200 nanomètres, respectivement.

Le matériau diélectrique est, par exemple, de l'oxyde de tantale (Ta₂O₅), de l'oxyde d'hafnium (HfO₂), de l'oxyde de titane (TiO₂), de l'alumine (Al₂O₃), ou tout autre oxyde mixte isolant associant des atomes métalliques de plusieurs types. Un matériau diélectrique à permittivité diélectrique élevée est utilisé de façon préférée, pour augmenter la capacité du condensateur obtenu. Le premier matériau métallique peut être du cuivre, de l'aluminium, du nitrure de titane (TiN), du nitrure de tantale (TaN), du tungstène, ou tout métal, composé ou alliage métallique compatible avec le procédé de dépôt utilisé.

Le matériau temporaire de la couche 1a est sélectionné pour pouvoir être gravé sélectivement dans la suite du procédé.

Le matériau temporaire est aussi sélectionné de façon à obtenir, lors de la réalisation de la couche 2, une structure régulière et homogène de la couche 2 selon des directions parallèles à la surface du substrat 100. Une telle structure régulière résulte généralement d'une germination uniforme du matériau de la couche 2 sur le matériau temporaire.

Le matériau temporaire est aussi sélectionné pour être inerte chimiquement vis-à-vis du matériau diélectrique, et vis-à-vis des espèces chimiques qui interviennent lors de sa formation. Il est en outre sélectionné de façon à ne pas engendrer de diffusions atomiques en direction du matériau diélectrique.

Ces exigences de sélection du matériau temporaire peuvent être satisfaites d'autant plus facilement que le matériau temporaire n'est pas nécessairement un métal ni un alliage métallique. Le matériau temporaire peut être, par exemple, le germanium ou un alliage de silicium et de germanium. Ce peut être aussi, éventuellement, un matériau métallique qui satisfait ces mêmes exigences.

La couche 2 peut être déposée par un procédé chimique, de type dépôt chimique en phase vapeur (ou CVD pour «Chemical Vapour Deposition», en anglais). Des conditions de dépôt du matériau diélectrique sont mises en oeuvre, qui sont particulièrement adaptées pour obtenir une couche 2 régulière et uniforme. Notamment, une vitesse de dépôt faible peut être adoptée, et le dépôt est préférablement effectué avec une basse pression régnant dans l'enceinte de dépôt utilisée. En particulier, un procédé de formation du matériau diélectrique par couches atomiques successives superposées peut être utilisé.

Les couches 1a, 2 et 3 sont ensuite gravées en combinant un ou plusieurs procédés de gravure humide («wet etching» en anglais) ou de gravure sèche («dry etching») avec l'utilisation de masques lithographiques. On obtient alors la structure représentée sur la figure 2. Cette structure comprend des volumes 1a, 2 et 3, correspondant respectivement aux couches précédentes de mêmes références. Les volumes 1a, 2 et 3 sont empilés selon la direction D au dessus d'une portion P du substrat 100. Pour des raisons qui apparaîtront par la suite, le volume 1a est appelé fausse armature inférieure. La couche 3 peut présenter une extension, selon une direction parallèle à la surface S, plus courte que l'extension des couches 1a et 2 selon la même direction. Elle présente alors au moins un retrait R, voire deux retraits R situés à des extrémités opposées de la couche 3. Ces retraits R correspondent à des parties découvertes de la surface supérieure du volume 2.

On dépose alors sur le circuit un matériau d'enrobage 4 pouvant être, par exemple, de la silice. Le matériau 4 recouvre les volumes 1a, 2 et 3 dans la portion P du substrat 100, et recouvre le substrat 100 en dehors de la portion P. La surface supérieure S du matériau 4 est polie jusqu'à former un plan parallèle à la surface du substrat 100.

On forme alors deux cheminées d'accès C1 et C2 parallèles à la direction D, à partir de la surface S. Les cheminées C1 et C2 sont formées au niveau des retraits R, afin de ne pas entrer en contact avec le volume 3. La section des cheminées C1 et C2 est définie par des ouvertures d'un masque lithographique non représenté. Les cheminées C1 et C2 sont formées par gravure sèche directionnelle, en utilisant un plasma de gravure dont une partie des ions est dirigée contre la surface S, selon la direction D et en sens opposé à celle-ci, par les ouvertures du masque. La configuration du circuit illustrée par la figure 3 est obtenue.

On introduit alors, par les cheminées C1 et C2, une solution liquide de gravure sélective du matériau temporaire du volume 1a. Si le matériau temporaire est le germanium ou un alliage de silicium et de germanium, une solution à la fois oxydante et acide peut être utilisée, qui ne dégrade pas le matériau d'enrobage 4, ni le matériau diélectrique du volume 2, ni le matériau de la couche 101. On obtient alors une gravure isotrope du matériau temporaire, éliminé par dissolution dans la solution. Une portion du volume 1 a est ainsi évidée, de façon à former une cavité C (figure 4).

Alternativement, le matériau temporaire peut être éliminé par une gravure sèche, isotrope et sélective, à l'aide d'un plasma pénétrant par les cheminées C1 et C2 jusqu'au volume 1a.

Les volumes 2 et 3 sont maintenus à distance de la surface supérieure de la couche 101, séparés de celle-ci par la cavité C, par le matériau d'enrobage 4. Le matériau 4 établit en effet une liaison d'appui sur la surface supérieure de la couche 101, en dehors de la portion P, et adhère aux volumes 2 et 3 de façon à suspendre ces derniers au dessus de la couche 101.

Un second matériau métallique est alors introduit dans la cavité C, par les cheminées C1 et C2 (figure 5). De façon préférée, le second matériau métallique est formé dans la cavité C par un dépôt chimique en phase vapeur, ou CVD («Chemical Vapour Deposition», en anglais). Pour cela, le circuit est chauffé. Un gaz contenant des précurseurs métalliques volatiles, organométalliques ou chlorures par exemple, est alors amené au contact de la surface S. Les précurseurs pénètrent dans les cheminées C1 et C2, et se décomposent thermiquement au contact des parois de la cavité C en formant le matériau métallique. Un volume rempli 1b est ainsi obtenu à la place de la cavité C.

Le second matériau métallique peut être, mais non nécessairement, identique au premier matériau métallique. Il peut être sélectionné, alternativement, parmi des composés métalliques qui présentent une valeur élevée de travail de sortie («work function» en anglais) par rapport au matériau diélectrique. En pratique, des valeurs de travail de sortie supérieures à 5 électrons-volts sont particulièrement recherchées.

Le second matériau métallique est simultanément déposé dans la cavité C et dans les cheminées d'accès C1, C2. La section de chaque cheminée C1, C2 est déterminée de façon à ce que chaque cheminée C1, C2 ne soit pas fermée avant qu'une quantité suffisante de matériau métallique ait été déposée dans la cavité C. Il n'est pas nécessaire que la cavité C soit entièrement remplie de matériau métallique, mais, à l'issue de l'étape d'introduction du second matériau métallique dans la cavité C, au moins la portion de la surface inférieure de la couche 2 située dans la cavité doit être recouverte de second matériau métallique.

Un tel recouvrement n'est obtenu, pour une section donnée des cheminées C1 et C2, que si les deux cheminées ne sont pas trop éloignées l'une de l'autre. Si le condensateur possède une grande dimension parallèle à la surface du substrat, il peut être alors nécessaire de prévoir des cheminées d'accès supplémentaires, régulièrement disposées le long de cette dimension. Les inventeurs ont observé que, pour des cheminées d'accès ayant une section circulaire de diamètre de 150 nanomètres environ, deux cheminées voisines ne doivent pas être séparées d'une distance excédant 10 à 20 fois la hauteur h de la cavité C parallèlement à la direction D. Dans ces conditions, un dépôt continu de second matériau métallique est obtenu, qui recouvre entièrement les parois de la cavité C. Cette distance maximale entre les cheminées d'accès pourra être augmentée en fonction d'améliorations du procédé de dépôt utilisé pour le second matériau métallique.

Si l'armature inférieure présente de petites dimensions parallèlement à la surface du substrat 100, une unique cheminée d'accès peut suffire pour vider la cavité C du matériau temporaire puis la remplir de second matériau métallique.

La surface supérieure du circuit S est de nouveau polie, pour éliminer un dépôt de second matériau métallique formé sur celle-ci. Selon la figure 6, des connexions électriques 13 parallèles à la direction D sont formées, entre le volume 3 et la surface S. Le volume 3 constitue alors l'armature supérieure du condensateur MIM. Le volume 1b constitue l'armature inférieure du condensateur, et les cheminées C1 et C2 remplies de second matériau métallique constituent deux connexions électriques 11 et 12 disposées entre l'armature inférieure et la surface S. Grâce aux retraits R, les connexions 11 et 12 sont isolées de l'armature supérieure.

La réalisation du circuit est alors poursuivie d'une façon connue en soi. En particulier, des composants intégrés 102 peuvent être disposés au-dessus du condensateur.

De nombreuses variantes peuvent être introduites dans le procédé décrit ci-dessus en détail. Ces variantes font partie de l'invention dans la mesure où le procédé résultant met en oeuvre une fausse armature inférieure, remplacée par la suite par une armature définitive en matériau conducteur. En particulier, le volume de matériau diélectrique qui sépare les armatures du condensateur peut être remplacé par un volume stratifié selon la direction D, rempli par plusieurs couches de matériaux distincts superposées ou formées les unes à l'intérieur des autres. De même, l'empilement des volumes 1a, 2 et 3 sur le substrat 100, correspondant à la figure 2, peut être réalisé de nombreuses manières équivalentes.

Une autre variante du procédé décrit ci-dessus consiste à remplacer la configuration essentiellement plane des différents volumes du condensateur superposés selon une direction perpendiculaire à la surface du substrat par une configuration selon laquelle ces différents volumes sont essentiellement parallèles les uns aux autres, mais peuvent avoir des formes quelconques. En particulier, le condensateur peut être formé dans une cavité ayant un axe de symétrie, et les différents volumes peuvent être disposés d'une façon coaxiale par rapport à l'axe de symétrie de la cavité.

## Revendications

1. Procédé de réalisation d'un circuit électronique intégré comprenant un condensateur (1b, 2, 3), le procédé comprenant les étapes suivantes :
a) formation d'un empilement comprenant :
- un premier volume d'un matériau temporaire (1a) disposé sur une partie (P) d'un substrat (100, 101),
- un second volume d'au moins un matériau diélectrique isolant électriquement (2) disposé sur le premier volume (1a), d'un côté du premier volume opposé au substrat, et
- un troisième volume d'un premier matériau conducteur électrique (3) disposé au-dessus du deuxième volume (2), d'un côté du deuxième volume opposé au premier volume, de façon à former une première armature du condensateur ;
b) dépôt d'un matériau d'enrobage isolant électrique (4) sur le circuit de façon à recouvrir l'empilement et une partie au moins du circuit en dehors de ladite partie du substrat (P) ;
c) formation d'au moins une cheminée d'accès (C1, C2) entre une surface (S) du matériau d'enrobage (4) et le premier volume (1a);
d) évacuation d'une partie au moins du matériau temporaire par la cheminée d'accès (C1, C2) de façon à évider une portion au moins du premier volume (1a) ; et
e) introduction d'un second matériau conducteur par la cheminée d'accès (C1, C2) dans la portion évidée du premier volume, de façon à former une seconde armature du condensateur (1b).

2. Procédé selon la revendication 1, dans lequel, lors de l'étape e), le second matériau conducteur est déposé dans la portion évidée du premier volume et dans la cheminée d'accès (C1, C2).

3. Procédé selon la revendication 1 ou 2, dans lequel les premier et second matériaux conducteurs sont des matériaux métalliques.

4. Procédé selon l'une quelconque des revendications précédentes, comprenant en outre la réalisation de composants intégrés (102) disposés au-dessus du condensateur (1b, 2, 3), d'un côté du condensateur opposé au substrat (100, 101).

## Claims

1. Process for producing an integrated electronic circuit that includes a capacitor (1b, 2, 3), the process comprising the following steps:
a) formation of a stack comprising:
- a first volume (1a) of temporary material placed on a part (P) of a substrate (100, 101),
- a second volume (2) of at least one electrically insulating dielectric placed on the first volume (1a), on an opposite side of the first volume from the substrate and
- a third volume (3) of a first electrically conducting material placed above the second volume (2), on an opposite side of the second volume from the first volume, so as to form a first electrode of the capacitor;
b) deposition of an electrically insulating coating material (4) on the circuit so as to cover the stack and at least part of the circuit away from said substrate part (P);
c) formation of at least one access shaft (C1, C2) between a surface (S) of the coating material (4) and the first volume (1a);
d) removal of at least part of the temporary material via the access shaft (C1, C2) so as to hollow out at least one portion of the first volume (1a); and
e) introduction of a second conducting material via the access shaft (C1, C2) in the hollowed-out portion of the first volume, so as to form a second electrode of the capacitor (1b).

2. Process according to Claim 1, wherein, during step e), the second conducting material is deposited in the hollowed-out portion of the first volume and in the access shaft (C1, C2).

3. Process according to Claim 1 or 2, wherein the first and second conducting materials are metallic materials.

4. Process according to any one of the preceding claims, furthermore comprising the production of integrated components (102) placed above the capacitor (1b, 2, 3) on an opposite side of the capacitor from the substrate (100, 101).

## Patentansprüche

1. Verfahren zur Herstellung einer elektronischen integrierten Schaltung, umfassend einen Kondensator (1b, 2, 3), wobei das Verfahren die nachfolgenden Schritte umfasst:
a) Bilden eines Stapels, umfassend:
- ein erstes Volumen aus einem temporären Material (1a), welches auf einem Teil (P) eines Substrats (100, 101) angeordnet wird,
- ein zweites Volumen aus wenigstens einem elektrisch isolierenden, dielektrischen Material (2), welches auf dem ersten Volumen (1a) auf einer dem Substrat gegenüberliegenden Seite des ersten Volumens angeordnet wird,
- ein drittes Volumen aus einem ersten elektrisch leitenden Material (3), welches oberhalb des zweiten Volumens (2) auf einer dem ersten Volumen gegenüberliegenden Seite des zweiten Volumens derart angeordnet wird, dass eine erster Kondensatorbelag gebildet wird;
b) Ablagern eines elektrisch isolierenden Ummantelungsmaterials (4) auf der Schaltung, derart, dass der Stapel und wenigstens ein Teil der Schaltung ausserhalb des Substratteils (P) bedeckt wird;
c) Bilden von wenigstens einem Zugangsschacht (C1, C2) zwischen einer Oberfläche (S) des Ummantelungsmaterials (4) und dem ersten Volumen (1a);
d) Entfernen eines Teils wenigstens des temporären Materials durch den Zugangsschacht (C1, C2), derart, dass ein Teil wenigstens des ersten Volumens (1a) ausgehöhlt wird; und
e) Einführen eines zweiten leitenden Materials durch den Zugangsschacht (C1, C2) in den ausgehöhlten Teil des ersten Volumens, derart, dass ein zweiter Kondensatorbelag (1b) gebildet wird.

2. Verfahren nach.Anspruch 1, bei dem beim Schritt e) das zweite leitende Material in dem ausgehöhlten Teil des ersten Volumens und in dem Zugangsschacht (C1, C2) abgelagert wird.

3. Verfahren nach Anspruch 1 oder 2, bei dem das erste und das zweite leitende Material metallische Materialien sind.

4. Verfahren nach einem der vorhergehenden Ansprüche, ferner umfassend die Herstellung von integrierten Komponenten (102), welche auf dem Kondensator (1b, 2, 3) auf einer dem Substrat (100, 101) gegenüberliegenden Seite des Kondensators angeordnet werden.
